(19) Europäisches Patentamt

European Patent Office

Office européen des brevets

(11) EP 1 030 375 A1

(12) **EUROPEAN PATENT APPLICATION**
published in accordance with Art. 158(3) EPC

(43) Date of publication:
23.08.2000 Bulletin 2000/34

(51) Int. Cl.$^7$: **H01L 29/868**

(21) Application number: 98941792.8

(86) International application number:
**PCT/JP98/04055**

(22) Date of filing: 10.09.1998

(87) International publication number:
**WO 00/16408 (23.03.2000 Gazette 2000/12)**

(84) Designated Contracting States:
CH DE LI

(71) Applicant:
**MITSUBISHI DENKI KABUSHIKI KAISHA**
**Tokyo 100-8310 (JP)**

(72) Inventors:
• **MORISHITA, Kazuhiro**
  **Mitsubishi Denki K. K.**
  **Chiyoda-ku Tokyo 100-8310 (JP)**

• **SATOH, Katsumi**
  **Mitsubishi Denki K. K.**
  **Chiyoda-ku Tokyo 100-8310 (JP)**
• **KOGA, Shinji**
  **Mitsubishi Denki K. K.**
  **Chiyoda-ku Tokyo 100-8310 (JP)**

(74) Representative:
**Popp, Eugen, Dr. et al**
**MEISSNER, BOLTE & PARTNER**
**Postfach 86 06 24**
**81633 München (DE)**

(54) **SEMICONDUCTOR DEVICE AND ITS MANUFACTURING METHOD**

(57)    A method for manufacturing a semiconductor device according to the invention comprises an N-type semiconductor substrate which contains N-type impurities and has a predetermined resistance value, a P layer consisting of a P-type electric conductor formed on one face of the N-type semiconductor substrate, an N$^+$ layer which is formed on the other face of the N-type semiconductor substrate and consists of a high concentration N-type electric conductor and a buffer layer formed by heat treatment after irradiating ion of small mass to the vicinity of said N$^+$ layer of the N-type semiconductor substrate. A resistance value of the buffer layer is established to be a value between resistance values of the N-type semiconductor substrate and the N$^+$ layer. The semiconductor device can be formed by changing resistance value of only a region having a predetermined depth without being influenced by heat treatment after ion implantation.

Fig.1

## Description

Technical Field

The present invention relates to a semiconductor device such as diode including reflux diode and voltage clamp diode which are used for application to a switching element highly resistant to pressure in which high resistance to pressure and swift reverse recovery characteristic are required. The invention also relates to a method for manufacturing such a semiconductor device.

Background Art

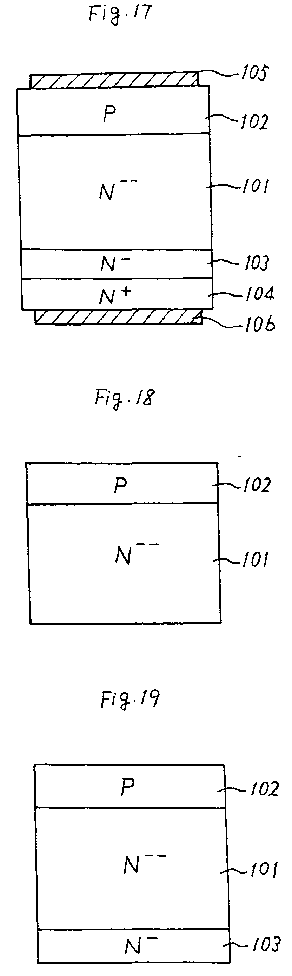

Fig. 17 illustrates a sectional view of a diode which is a conventional semiconductor device described in the Japanese Patent Publication (unexamined) No.8-316500. In the drawing, numeral 101 is an N⁻⁻ layer in which N-type impurities of a low concentration are introduced into an N-type semiconductor substrate such as silicon, and numeral 102 is a P layer consisting of a P-type semiconductor formed on one main face of the N⁻⁻ layer 101. Numeral 103 is an N⁻ layer in which N-type impurities are introduced on the other main face of the N⁻⁻ layer 101 so that the impurity concentration becomes higher than that of the N⁻⁻ layer. Numeral 104 is an N+ layer formed on a face of the N⁻ layer 103 opposite to the face neighboring to the N⁻⁻ layer 101, and in which the impurity concentration is arranged to be higher than that of the N⁻ layer 103 for ohmic contact with a cathode electrode. Numeral 105 is an anode electrode made of metal and arranged on an exposed face of the P layer 102 (a face opposite to the joining face with the N⁻⁻layer 101). Numeral 106 is the cathode electrode made of metal and arranged on an exposed face of the N⁺ layer 104 (a face opposite to the neighboring face with the N⁻ layer 103).

Next, the semiconductor device shown in Fig. 17 is manufactured as described below. Fig. 18 to Fig. 21 are drawings for explaining a manufacturing method of the semiconductor device shown in Fig. 17.

First, as shown in Fig. 18, the P layer 102 is formed by introducing B, Ga, In, etc. through ion implantation from one main face of the N-type semiconductor substrate that forms the N⁻⁻ layer 101 where N-type impurities of a low concentration are introduced.

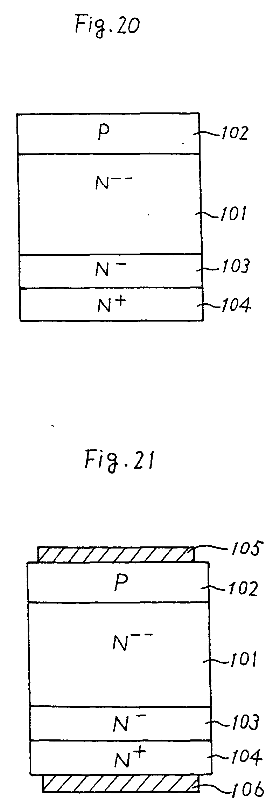

Next, as shown in Fig. 19, P, As, Sb, etc. are introduced through ion implantation from the other main face of the N-type semiconductor substrate (a face of the N⁻⁻ layer 101 opposite to the P layer 102). Thus the N⁻ layer 103 is formed on the other main face of the N-type semiconductor substrate.

Next, as shown in Fig. 20, P, As, Sb, etc. are further introduced from the face on the side of N⁻ layer 103 of the N-type semiconductor substrate, where the N⁻ layer 103 is formed. Thus the N+ layer 104 of an impurity concentration higher than that of the N⁻ layer 103 is formed.

In the foregoing impurity introduction, predetermined conductive impurity ions such as B, Ga, P, As, Sb, etc. are irradiated from one face of the N-type semiconductor substrate at approximately 10 to 400 keV. At this time, a defect is generated along the range of the ions being a kind of heavily charged particles, and a medium in the range becomes amorphous. After that, an amorphous layer generated through this ion implantation is treated with heat at approximately 500°C in order to recover crystallinity, and the impurities are introduced to this region.

After the N+ layer 104 is formed as described above, as shown in Fig. 21, the cathode electrode 105 and the anode electrode 106, which consist of electric conductors, are formed on the P layer 102 and the N+ layer 104 respectively. Thus the semiconductor device illustrated in Fig. 17 is formed.

In the conventional semiconductor device of above structure, since the N⁻ layer is formed by introducing impurity ions, it is necessary to appropriately control the heat treatment (the amount of heat and the time of treatment) after the impurity ion introduction in order to obtain a desired resistance value. Without appropriate heat treatment, the introduced impurities are diffused, and the resistance value (the impurity concentration) is changed and they are not formed at an appropriate formation position. This causes a problem that even in the heat treatment of other portion conducted after the impurity ion introduction, it is required to pay an attention not to influence the portion where the impurity ions are introduced.

In the conventional method for manufacturing the semiconductor device, it is necessary to appropriately control the heat treatment after the impurity ion introduction as explained above. Moreover, in the conventional semiconductor device, an impurity region is formed by implanting a heavy ion such as As, Sb, Se, Te, etc. Therefore in the case of forming the impurity region at a predetermined depth from the face where the ions are implanted, a further impurity region is continuously formed also in the region from the ion implantation face to the implanted portion of the predetermined depth. This affects negatively or influences the impurity concentration of the region near the ion implantation face, and it is impossible to change only the resistance value of the desired position.

The invention was made to solve the above-discussed problems, and has an object of providing a semiconductor device and a method of making the same in which a resistance value of only a region having a predetermined depth is changed without being influenced by heat treatment conducted after ion implantation.

The invention has another object of providing a semiconductor device having a desired resistance value at a desired selected position.

Disclosure of the Invention

A semiconductor device according to the invention comprising an N-type semiconductor substrate which contains N-type impurities and has a predetermined resistance value, a P layer consisting of a P-type electric conductor formed on one face of said N-type semiconductor substrate, an N$^+$ layer which is formed on the other face of the N-type semiconductor substrate and consists of a high concentration N-type electric conductor and a buffer layer formed by heat treatment after irradiating ion of small mass to the vicinity of said N$^+$ layer of said N-type semiconductor substrate, a resistance value of the buffer layer being established to be a value between resistance values of the N-type semiconductor substrate and the N$^+$ layer. As a result, it is possible to form the buffer layer without being influenced by the heat treatment conducted after the ion implantation, slow down formation of a depletion layer owing to this buffer layer, and prevent generation of voltage oscillation at the last stage of reverse recovery operation.

The "ions of small mass" used in this invention are ions of non-impurities smaller in mass as compared with ions normally used as N-type impurities, and do not act as N-type impurities by themselves. Preferable examples of such ions are proton, deuteron, helium, and alpha particle, and among them proton is most preferably used because it does not influence other layer that exists in the range when it is irradiated.

It has been well known to use ion irradiation with proton as a life time killer, but as far as the inventors know, it is heretofore unknown in the art to use ion irradiation with ions of small mass such as proton in order to lower a resistance value.

A semiconductor device according to the invention comprising a N-type semiconductor substrate which contains N-type impurities and has a predetermined resistance value, a P layer consisting of a P-type electric conductor formed on one face of said N-type semiconductor substrate, a N$^+$ layer consisting of a high concentration N-type semiconductor formed on the other face of the N-type semiconductor substrate and a buffer layer which is selectively formed near said N$^+$ layer of the N-type semiconductor substrate and has a resistance value which is set to be between resistance values of the N-type semiconductor substrate and the N+ layer. As a result, it is possible to enlarge the area where the N-type semiconductor substrate and the N$^-$ layer contact, slow down the formation of the depletion layer in this region, and prevent generation of voltage oscillation at the last stage of the reverse recovery operation.

It is preferable to form the buffer layer to be lattice-shaped or torus-shaped in a section of the N-type semiconductor substrate near the adjacent portion with the N$^+$ layer. In this case, it is possible to enlarge the area where the N-type semiconductor substrate and the buffer layer contact and form the buffer layer to be point symmetric with respect to the center of the semiconductor device, thereby improving thermal effect.

In a method for manufacturing a semiconductor device according to the invention, an N-type semiconductor portion of a decreased resistance value is obtained by irradiation with ions of small mass and applying heat treatment to the N-type semiconductor substrate which contains N-type impurities and has a predetermined resistance value. It is therefore possible to change only the resistance value of the region of the predetermined depth without being influenced by the heat treatment conducted after the ion implantation. Moreover, it is possible to lower the resistance value of the desired position without influencing the portion between the ion irradiation face and the N-type semiconductor portion where the resistance value was decreased.

It is also preferable to use non-impurity ions as the ions for irradiation onto the semiconductor. In this case, even when the implanted ions are diffused in the heat treatment, the resistance value (the impurity concentration) of this diffusion region remains unchanged and the heat treatment does not influence the region where the lattice defect is not formed.

It is also preferable to use one of proton, deuteron, helium, and alpha particle as the ions for irradiation onto the semiconductor. In this case, because the ions have small mass, it is possible to pass the ions through the lattice in the region between the ion irradiation face and the portion where the lattice defect is formed without any collision with the lattice. Therefore, the lattice in the region on the way is not influenced, and the lattice defect can be accurately formed at a desired position.

Furthermore, it is preferable that the temperature of heat treatment in the heating treatment process is set to be not lower than 500 °C and not higher than 1400 °C. In this case, it is possible to cause the formed lattice defect vanish, and decrease the resistance value of this portion owing to the impurities around the defect at the time of vanishing.

Brief Description of the Drawings

Fig. 1 is a sectional view showing a semiconductor device of mode 1 of the invention.
Fig. 2 is a top view showing the semiconductor device of mode 1 of the invention.
Fig. 3 illustrates resistivity of each layer of the semiconductor device shown in Fig. 1 and Fig. 2.
Fig. 4 illustrates a method for manufacturing the semiconductor device of mode 1 of the invention.
Fig. 5 illustrates the method for manufacturing the semiconductor device of mode 1 of the invention.
Fig. 6 illustrates the method for manufacturing the semiconductor device of mode 1 of the invention.

Fig. 7 illustrates the method for manufacturing the semiconductor device of mode 1 of the invention.

Fig. 8 illustrates the method for manufacturing the semiconductor device of mode 1 of the invention.

Fig. 9 illustrates impurity concentration, resistance, and resistivity of each layer of the semiconductor device shown in Fig. 1 and Fig. 2.

Fig. 10 is a graph for explaining operation of the semiconductor device shown in Fig. 1 and Fig. 2.

Fig. 11 is a diagram for explaining the operation of the semiconductor device shown in Fig. 1 and Fig. 2.

Fig. 12 is a graph for explaining the operation of the semiconductor device shown in Fig. 1 and Fig. 2.

Fig. 13 is a sectional view showing a semiconductor device of mode 2 of the invention.

Fig. 14 illustrates the semiconductor device of mode 2 of the invention.

Fig. 15 illustrates a semiconductor device of mode 3 of the invention.

Fig. 16 illustrates a semiconductor device of mode 3 of the invention.

Fig. 17 is a sectional view showing a conventional semiconductor device.

Fig. 18 illustrates a method for manufacturing the conventional semiconductor device.

Fig. 19 illustrates the method for manufacturing the conventional semiconductor device.

Fig. 20 illustrates the method for manufacturing the conventional semiconductor device.

Fig. 21 illustrates the method for manufacturing the conventional semiconductor device.

Best Mode for Carrying Out the Invention

The invention will be described in more detail with reference to the accompanying drawings.

Mode 1:

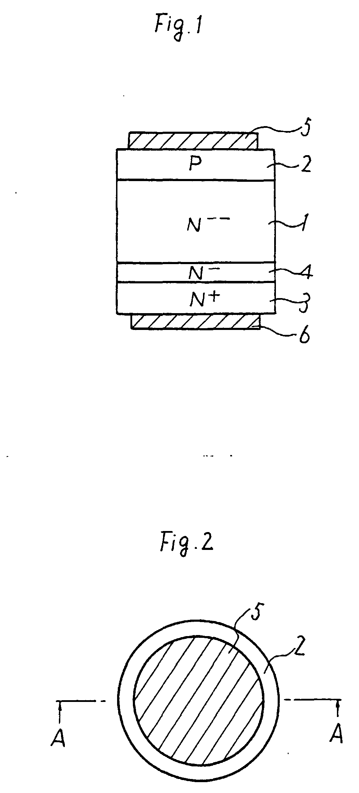

Fig. 1 is a sectional view showing a section of a semiconductor device according to mode 1 of the invention. Fig. 2 is a top view of the semiconductor device according to mode 1 of the invention when viewed from anode side, and Fig. 1 is a sectional view taken along the line A-A of the semiconductor device shown in Fig. 2.

In Fig. 1 and Fig. 2, reference numeral 1 is an $N^{--}$ layer of a predetermined resistance value wherein N-type impurities of a low concentration are introduced into an N-type semiconductor substrate such as silicon. Numeral 2 is a P layer consisting of a P-type semiconductor formed on one main face of the $N^{--}$ layer 1. Numeral 3 is an $N^+$ layer which is formed on the other main face of the $N^{--}$ layer 1 and has a high impurity concentration. Numeral 4 is an $N^-$ layer which is formed on a neighboring portion of the $N^{--}$ layer 1 with the $N^+$ layer 3 in order to buffer when a depletion layer is formed from the $N^{--}$ layer 1 to the $N^+$ layer 3. This $N^-$ layer 4 is a buffer layer not formed by introducing impurities but formed by conducting heat treatment after irradiation with ions of small mass. Resistance value of this $N^-$ layer is arranged to be lower than the resistance value of the $N^{--}$ layer 1 and higher than the resistance value of the $N^+$ layer 3. Numeral 5 is an anode electrode made of conductive metal and formed on an exposed face of the P layer 2 (a face opposite to the joining face with the $N^{--}$ layer 1). Numeral 6 is a cathode electrode made of conductive metal and formed on an exposed face of the $N^+$ layer 3 (a face opposite to the neighboring face with the $N^-$ layer 4).

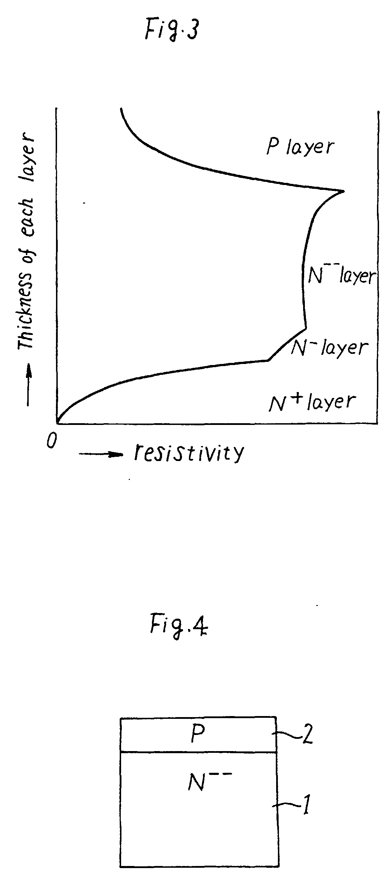

Fig. 3 shows a relation of resistivity in each layer of the semiconductor device shown in Fig. 1 and Fig. 2. As shown in the drawing, resistivity is arranged to be lowest in the $N^+$ layer 3 and highest in the $N^{--}$ layer 1. And resistivity of $N^-$ layer 4 formed between the $N^{--}$ layer 1 and the $N^+$ layer 3 is arranged to be a value between the resistivity of the $N^{--}$ layer 1 and the resistivity of the $N^+$ layer 3.

Next, the semiconductor device shown in Fig. 1 and Fig. 2 is manufactured as described below. Fig. 4 to Fig. 8 are drawings for explaining a manufacturing method of the semiconductor device shown in Fig. 1 and Fig. 2. In the drawings, numeral 4a is a lattice defect region formed by irradiation with non-impurity ions like proton onto the formation region of the $N^-$ layer 4. Description of other numerals in Fig. 4 to Fig. 8 are omitted herein because they are the same as those shown in Fig. 1 and Fig. 2.

First, as shown in Fig.4, an N-type semiconductor substrate, to which N-type impurities of a low concentration are introduced, is prepared, and this N-type semiconductor substrate is used as the $N^{--}$ layer 1. The impurity concentration of this $N^{--}$ layer 1 is required to be sufficiently low, and it is preferable that the impurity concentration is not higher than $1E^{14}$ ($cm^2$). B, Ga, In, etc. are introduced from one main face of this N-type semiconductor substrate through ion irradiation, and the P layer 2 is formed on the main face of the N-type semiconductor substrate.

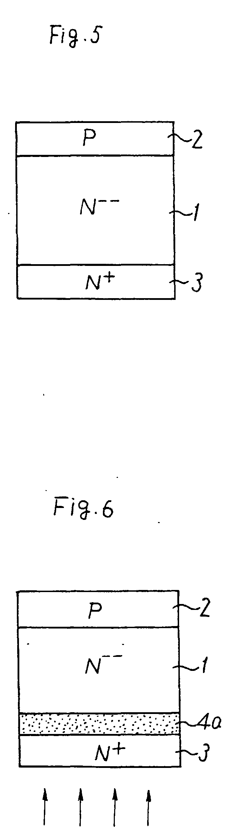

Next, as shown in Fig. 5, B, Ga, In, etc. are introduced from the other main face (a face of the $N^{--}$ layer 1 opposite to the P layer 2) of the N-type semiconductor substrate through ion irradiation. Thus, the $N^+$ layer 3 of an impurity concentration higher than that of the $N^{--}$ layer (of a lower resistance value) is formed.

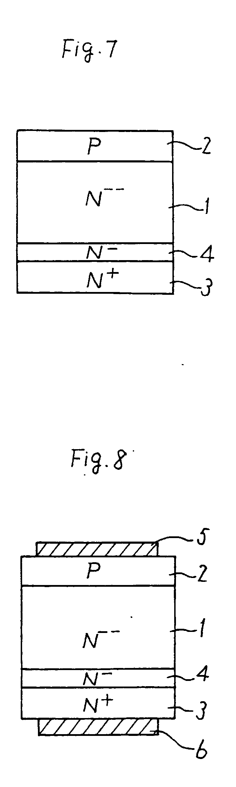

Next, as shown in Fig. 6 and Fig. 7, in order to form the $N^-$ layer, in which resistance value is lower than that of the $N^{--}$ layer 1 and higher than that of the $N^+$ layer 3, in the neighboring region of the $N^{--}$ layer 1 of the N-type semiconductor substrate, on which the $N^+$ layer 3 is formed, with the $N^+$ layer 3, the lattice defect region 4a is formed in the region to form the $N^-$ layer through the ion implantation process described below. After this ion implantation process, the semiconductor substrate is treated with heat through the heat treatment process described below, the lattice defect 4a is vanished, and the N⁻ layer 4 is formed by increasing the impurity concentration of this region.

Described below is the ion implantation process for forming the mentioned N⁻ layer.

As shown in Fig. 6, the lattice defect 4a is formed at a desired position by irradiation with ions of small mass normally used as life time control from the other main face (the face of the N⁻⁻ layer 1 opposite to the P layer 2) of the N-type semiconductor substrate. Kind of ions irradiated in this step is "ions of small mass", and they are non-impurity ions of smaller mass as compared with ions normally used as N-type impurities and do not function as N-type impurities by themselves. Preferable examples of such ions are proton ($1H^+$), deuteron ($2H^+$), helium ($3He^{2+}$), and alpha particle ($4He^{2+}$), and proton is the most favorable to be used among them because it does not influence other layer existing in the range when it is irradiated.

Using ions of small mass makes it possible to form the lattice defect 4a only at the desired position without influencing the region where they pass through (in this case, the $N^+$ layer 3). Irradiation energy in this ion irradiation is 2 to 23 (MeV), dose amount is $5E^{10}$ to $5E^{14}$ (ions / $cm^2$), and it is possible to set the irradiation depth to any depth, for example, 20 (μm), provided that the ions can be implanted. In this manner, the lattice defect region 4a is formed in the region to form the N⁻ layer by irradiation with ions.

Described below is the heat treatment process conducted after the foregoing ion implantation process.

After forming the lattice defect in the ion implantation process, as shown in Fig. 7, the lattice defect region 4a of the semiconductor device having the lattice defect region 4a shown in Fig. 6 is treated with heat, whereby the lattice defect is vanished. At this time, oxygen and a very small amount of impurities in silicon are attracted to the vanishing lattice defect, and the impurity concentration of this portion is increased in comparison with the former situation, and therefore the impurity concentration of this portion becomes higher. The temperature in this heat treatment may be a temperature at which the lattice defect is vanished and be not higher than the melting point of the substrate, and is normally 500 to 1400 °C, and preferably 500 to 1200 °C.

The time required for the heat treatment is a time in which the lattice defect is vanished and may be set to be a value corresponding to the temperature setting. This heat treatment is conducted under the atmosphere of nitrogen ($N_2$) gas.

As described above, after forming the N⁻ layer 4, the cathode electrode 5 and the anode electrode 6 consisting of electrode conductors are formed on the P layer 2 and the $N^+$ layer 3 respectively.

Thus, the semiconductor device shown in Fig. 1 and Fig. 2 is formed.

In the forgoing method, the heat treatment process is conducted before forming the electrodes 5, 6, but this order is not limited and the process can be conducted any time after the ion implantation process. Moreover, it is possible to diminish the heat treatment process and make it more effective by conducting the heat treatment at the time when another element that also requires a heat treatment process is formed.

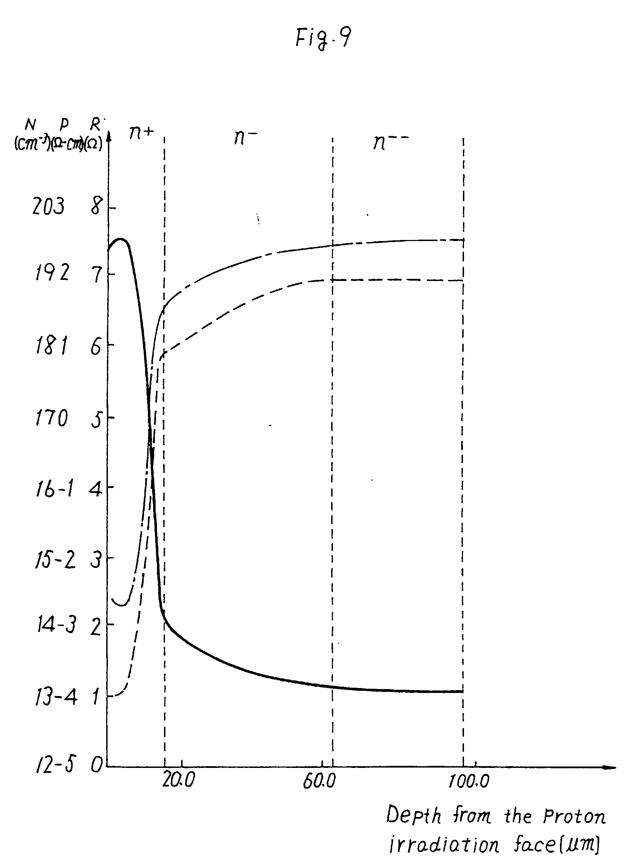

Fig. 9 illustrates a relation between impurity concentration, resistivity, and resistance and depth from the proton irradiation face in the foregoing semiconductor device. In the drawing, the axis of abscissas shows depth (μm) from the proton irradiation face, the axis of ordinates shows impurity concentration N (cm-3), resistivity ρ (Ω • cm), and resistance R (Ω), and the scale of the axis of ordinates is logarithmic.

A condition for obtaining the foregoing relation is that the substrate concentration is $1E^{14}$ ($cm^{-3}$), and conditions for the ion irradiation are that the irradiation ions are proton ($1H^+$), the irradiation energy is 18 (MeV), the dose amount is $5E^{12}$ (ions / $cm^2$), and the irradiation depth is 20 (μm), and conditions for the heat treatment are that the treatment temperature is 900°C, the heat treatment time is an hour, and the gas is $N_2$.

In this mode, the lattice defect is formed without influencing the region outside the desired region by irradiation with ions of small particles like proton, the lattice defect is then vanished through the subsequent heat treatment, and the impurity concentration of only this region is increased. Therefore, it is understood from Fig. 9 that although the N⁻ layer 4, of which impurity concentration is lower than that of the $N^+$ layer 3, is formed after the N+ layer 3 is formed, the N⁻ layer 4, of which impurity concentration is higher than that of the N⁻⁻ layer 1, is formed through the $N^+$ layer 3 without influence on the impurity concentration of the $N^+$ layer 3. It is also understood from Fig. 9 that concerning the resistivity ρ (and the resistance R) depending on the impurity concentration, the N⁻ layer 4, which is formed in the region between the $N^+$ layer 3 of low resistivity (resistance) and the N⁻⁻ layer 1 of high resistivity (resistance), possesses a resistivity (resistance) value between the resistivity (resistance) values of these two layers.

Described below is operation of the semiconductor device shown in Fig. 1 and Fig. 2 when a reverse bias voltage is applied.

Just after an operation condition is changed instantaneously from a situation in which a forward current IF flows to a diode in a forward direction to a situation in which a reverse bias is applied through switching operation of an external circuit, a reverse current transiently flows the diode.

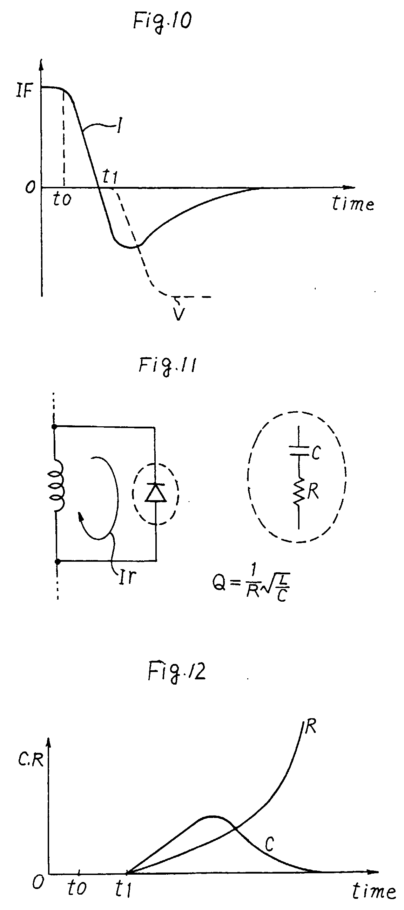

Fig. 10 shows a waveform of the current flowing through the diode in this transient situation. As shown in Fig. 10, when the situation in which a forward current IF flows steadily is switched to a situation in which the reverse bias is applied at a time t0, the current begins to decrease and becomes a minus value. In other words, a reverse current (a minus current) begins to flow through the diode.

This is because even when the reverse bias is applied, excess carriers remaining around a PN junction portion between the P layer 2 and the N⁻⁻ layer 1 prevent immediate formation of the depletion layer at the PN junction portion, and the diode is transiently in continuity.

While the reverse current increases, the depletion layer is generated at a time t1. Front of the depletion layer moves forward to the N+ layer 3 with the passage of time, which is followed by extension of the depletion layer covering all of the N⁻⁻ layer 1 and the N⁻ layer 4. With this extension of the depletion layer, a reverse voltage v generates at the time t1 between the anode electrode 5 and the cathode electrode 6, and after that, the reverse voltage v increases and converges to a value of reverse bias applied from outside. That is, reverse voltage inhibition capacity, an essential function of the diode is recovered as the depletion layer grows.

Along with the increase of the reverse voltage v, the reverse current slows down its increasing speed, reaches its peak and turns into decrease, and converges to 0. Thus, a transient situation, i.e. the reverse recovery operation is converged, and a steady situation, in which the reverse voltage v is equivalent to the reverse bias and the reverse current does not flow, is attained.

In the process of this reverse recovery operation, the depletion layer is generated after passing the time t1. When the depletion layer subsequently grows, as shown in Fig. 11, the diode is expressed equivalently with a series circuit formed between a capacitor in which a pair of electrodes are opposed putting the depletion layer between them and a leakage resistance in the depletion layer. As a result, in the process of the reverse recovery operation, a series resonant circuit is equivalently formed in combination of a capacitance C of the capacitor, a resistance R equivalent to the leakage resistance, and an inductance L existing in the external circuit. Any decrease in oscillation does not occur while the value of Q shown below is low, and oscillation is generated, whereby voltage oscillation is generated when the value of Q becomes high.

$$Q = 1/R \cdot (L/C)^{1/2} \qquad (1)$$

where: the capacitance C is defined by thickness of the depletion layer and density of the transient carriers, and the resistance R is defined by recombination current of the leakage current in the depletion layer and the excess carriers. As a result, the capacitor C and the resistance R change each drawing a curve as shown in the graph of Fig. 12 with the extension of the depletion layer.

The capacitance C is generated with the generation of the depletion layer, increases thereafter, reaches its peak, and turns into decrease. After that, the capacitance C is converged to 0 as a steady value. On the other hand, the resistance R is generated with the generation of the depletion layer, keeps on increasing thereafter, and increases rapidly at the last stage of the reverse recovery operation in contrast.

As shown in the foregoing expression (1), the value of Q becomes smaller as the resistance R and the capacitance C increase. Accordingly, at the last stage of the reverse recovery operation, in the case that the resistance R is not correspondingly large enough as in the conventional semiconductor device when the capacitance C is converged to 0, the value of Q becomes large and oscillation of voltage takes place. But in the semiconductor device according to this mode in which the N⁻ layer 4 is formed between the N⁻⁻ layer 1 and the N⁺ layer 3, formation speed of the depletion layer becomes slow owing to this N⁻ layer 4, and the resistance R is increased. This prevents occurrence of voltage oscillation at the last stage of the reverse recovery operation. As a result, it is possible to prevent occurrence of noise sources, which cause malfunction to the peripheral circuit, due to such oscillation of voltage.

In the semiconductor device according to the invention, ions of small mass are irradiated between the N⁻⁻ layer and the N⁺ layer, and the buffer layer (N⁻ layer) having a resistance value between those of the two layers is formed through the heat treatment conducted thereafter. It is therefore possible to form the buffer layer without being influenced by the heat treatment conducted after the ion implantation, and this buffer layer slows down the formation of the depletion layer and generation of voltage oscillation is prevented at the last stage of the reverse recovery operation.

In this mode, ions of small mass are irradiated from the ion irradiation face of the semiconductor device, and the lattice defect is formed in the region at the predetermined position from the ion irradiation face. Thereafter, the impurity concentration of this region is increased by heat treatment of the region where the lattice defect is formed. As a result, resistance value of only the region of a predetermined depth can be changed without being influenced by the heat treatment after the ion implantation. Moreover, impurity concentration of a desired position can be increased, without influencing from the ion irradiation face to the portion between the regions where impurity concentration was increased.

In this mode, the ions irradiated onto the semiconductor are non-impurity ions. Therefore, there is no change in resistance value (the impurity concentration) of this region where the ions are diffused even when the implanted ions are diffused in the heat treatment. As a result, the region where the lattice defect is not formed is not influenced by the heat treatment.

Moreover, in this mode, the ions for irradiation onto the semiconductor are ions of small mass such as proton, deuteron, helium, alpha particle, etc. Therefore, the ions can pass through the lattice in the region from the ion irradiation face to the portion where the lattice defect is formed without collision with the lattice. Thus, the lattice defect can be accurately formed at a desired position without influence on the lattice in the region located on the way.

Furthermore, in this mode, the temperature of the heat treatment in the heat treatment process is not lower than 500°C and not higher than 1400°C, and therefore the formed lattice defect is vanished, and when it is vanished, the impurity concentration of this portion is increased owing to the impurities existing around the defect.

Mode 2

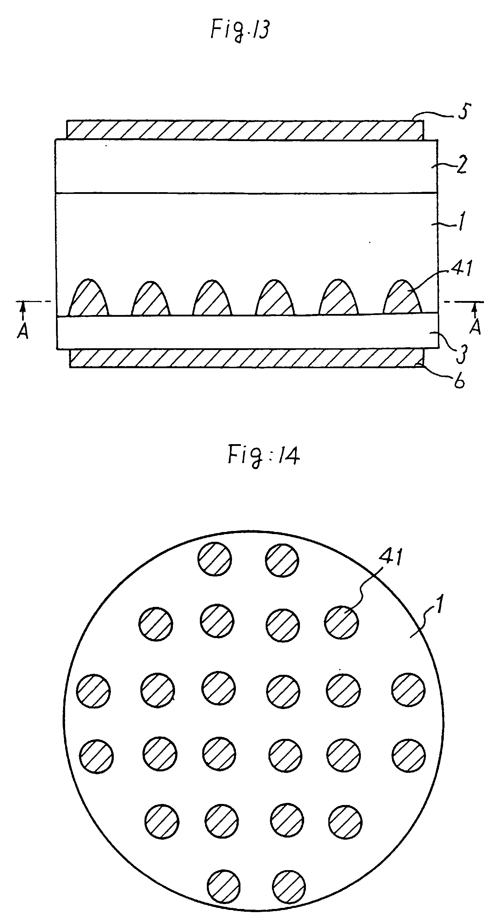

Fig. 13 is a sectional view showing a section of the semiconductor device according to mode 2 of the invention. Fig. 14 is a sectional view taken along the line A-A of the semiconductor device shown in Fig. 13. Numeral 1 is an N⁻⁻ layer wherein impurities of a low concentration are introduced into an N-type semiconductor substrate such as silicon, and numeral 2 is a P layer consisting of a P-type semiconductor formed on one main face of the N⁻⁻ layer 1. Numeral 3 is an N⁺ layer of a high impurity concentration formed on the other main face of the N⁻⁻ layer 1, and numeral 5 is an anode electrode made of conductive metal and formed on an exposed face of the P layer 2 (a face opposite to the joining face with the N⁻⁻ layer 1). Numeral 6 is a cathode electrode made of a conductive metal and formed on an exposed face of the N⁺ layer 3 (a face opposite to the neighboring face with an N⁻ layer 41). Numeral 41 is a N⁻ layer formed in the neighboring portion of the N⁻⁻ layer 1 with the N⁺ layer 3 in order to buffer when a depletion layer is formed from the N⁻⁻ layer 1 to the N+ layer 3. Resistance value of this N⁻ layer is set to be lower than the resistance value of the N⁻⁻ layer 1 and higher than the resistance value of the N+ layer 3. This N⁻ layer 41 is selectively formed in the neighboring portion of the N⁻⁻ layer 1 with the N+ layer 3, and as shown in Fig. 14, the N⁻ layer 41 is lattice-shaped, more specifically, spot-shaped in the A-A section of the semiconductor device. In addition, uniform heat conduction is achieved by forming each lattice-shaped N⁻ layer 41 to be point symmetric with respect to the center of the semiconductor substrate.

Next, a manufacturing method of a semiconductor device shown in Fig. 13 and Fig. 14 is hereinafter described. This manufacturing method is same as the method according to mode 1 except the formation method of the N⁻ layer 41, and repetition of description is omitted herein. In the foregoing mode 1, the lattice defect is uniformly formed in the N⁻⁻ layer 1 by uniform irradiation with ions of small mass in the ion implantation process. On the other hand, in this mode 2, the lattice defect is selectively formed in the N⁻⁻ layer 1 by selective irradiation with said ions only on the formation region of the N⁻ layer 41 shown in Fig. 14. Then, the heat treatment process is conducted in the same manner as in mode 1, whereby the N⁻ layer 41 is formed by increasing impurity concentration of this region.

Next, operation of the semiconductor device shown in Fig. 13 and Fig. 14 when a reverse bias voltage is applied is described below. This operation is also almost the same as that in mode 1, and therefore only the points different from mode 1 are described and further description is omitted herein.

In the foregoing mode 1, formation speed of the depletion layer is slow owing to the N⁻ layer 4 formed between the N⁻⁻layer 1 and the N⁺ layer 3, and the resistance R at the last stage of the reverse recovery operation is increased, thereby preventing generation of voltage oscillation at the last stage of the reverse recovery operation. On the other hand, in this mode 2, as shown in Fig. 13, the area where the N⁻⁻ layer 1 and the N⁻ layer 41 contact is enlarged by selectively forming the N⁻ layer 41. This further slows down the formation speed of the depletion layer formed in this region. As a result, the resistance R at the last stage of the reverse recovery operation becomes large, and generation of voltage oscillation is prevented at the last stage of the reverse recovery operation.

In this mode, since the N⁻ layer is selectively formed in the contact portion of the N⁻⁻ layer with the N⁺ layer, the area where the N⁻⁻ layer and the N⁻ layer contact can be increased. As a result, it is possible to slow down the formation of the depletion layer in this region and prevent generation of voltage oscillation at the last stage of the reverse recovery operation.

Mode 3:

The semiconductor device according to this mode 3 is a modification of the semiconductor device shown in Fig. 13 and Fig. 14 according to the foregoing mode 1, and in which the N⁻ layer in the A-A section of the semiconductor device shown in Fig. 13 is different.

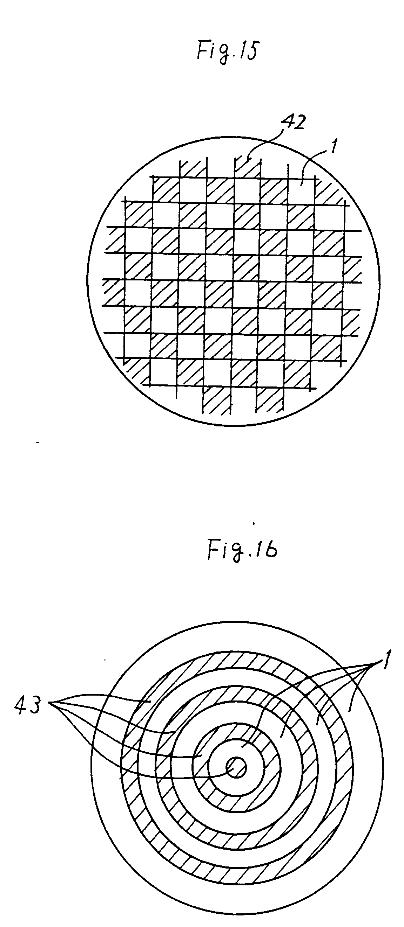

Fig. 15 shows the semiconductor device according to this mode 3 and is a sectional view taken along the line A-A of the semiconductor device shown in Fig. 13. In the drawing, numeral 1 is an N⁻⁻ layer. Numeral 42 is an N⁻ layer formed in the neighboring portion of the N⁻⁻ layer 1 with the N⁺ layer 3 and is selectively formed in the neighboring portion of the N⁻⁻ layer 1 with the N⁺ layer 3. As shown in Fig. 15, the N⁻ layer 42 is lattice-shaped, more specifically, diced in the A-A section of the semiconductor device.

Fig. 16 shows another semiconductor device according to mode 3, and is a sectional view taken along the line A-A of the semiconductor device shown in Fig. 13. In the drawing, numeral 1 is an N⁻⁻ layer, and numeral 43 is an N⁻ layer formed in the neighboring portion of the N⁻⁻ layer 1 with the N⁺ layer 3, which is selectively formed in the neighboring portion of the N⁻⁻ layer 1 with the N⁺ layer 3. As shown in Fig. 16, the N⁻ layer 43 is torus-shaped in the A-A section of the semiconductor device.

In this mode, the N$^-$ layer is selectively formed in the contact portion of the N$^{--}$ layer with the N$^+$ layer, and this increases the area where the N$^{--}$ layer and the N$^-$ layer contact. As a result, formation of the depletion layer in this region can be slow down, and generation of voltage oscillation can be prevented at the last stage of the reverse recovery operation.

Industrial Applicability

As has been described so far, the semiconductor device according to the invention is applicable to a semiconductor device such as diode, in which a high resistance to pressure and a swift reverse recovery characteristic are essential, including a reflux diode and a voltage clamp diode used for application to a switching element highly resistant to pressure such as IGBT (Insulated Gate Bipolar Transistor), GCT (Gate Commutated Turn-off Thyristor). The manufacturing method of the semiconductor device according to the invention is also applicable to a manufacturing method of such a semiconductor device.

**Claims**

1. A semiconductor device comprising:

   an N-type semiconductor substrate which contains N-type impurities and has a predetermined resistance value;
   a P layer consisting of a P-type electric conductor formed on one face of said N-type semiconductor substrate;
   an N$^+$ layer which is formed on the other face of said N-type semiconductor substrate and consists of a high concentration N-type electric conductor; and
   a buffer layer formed by heat treatment after irradiating ions of small mass to the vicinity of said N$^+$ layer of said N-type semiconductor substrate;
   wherein resistance value of said buffer layer being established to be a value between resistance values of said N-type semiconductor substrate and said N$^+$ layer.

2. The semiconductor device as set forth in claim 1, wherein said buffer layer is selectively formed in the vicinity of said N$^+$ layer of said N-type semiconductor substrate.

3. The semiconductor device as set forth in claim 2, wherein said buffer layer is lattice-shaped in a section in the vicinity of said N$^+$ layer of said N-type semiconductor substrate.

4. The semiconductor device as set forth in claim 2, wherein said buffer layer is torus-shaped in a section in the vicinity of said N$^+$ layer of said N-type semiconductor substrate.

5. A semiconductor device comprising:

   a N-type semiconductor substrate which contains N-type impurities and has a predetermined resistance value;
   a P layer consisting of a P-type electric conductor formed on one face of said N-type semiconductor substrate;
   a N$^+$ layer consisting of a high concentration N-type semiconductor formed on the other face of said N-type semiconductor substrate; and
   a buffer layer which is selectively formed near said N$^+$ layer of said N-type semiconductor substrate and has a resistance value which is set to be between resistance values of said N-type semiconductor substrate and said N+ layer.

6. The semiconductor device as set forth in claim 5, wherein said buffer layer is lattice-shaped in a section in the vicinity of said N$^+$ layer of said N-type semiconductor substrate.

7. The semiconductor device as set forth in claim 5, wherein said buffer layer is torus-shaped in a section in the vicinity of said N$^+$ layer of said N-type semiconductor substrate.

8. A method for manufacturing a semiconductor device, wherein ions of small mass are irradiated onto an N-type semiconductor substrate which contains N-type impurities and has a predetermined resistance value, and subsequently applies a heat treatment, thereby forming an N-type semiconductor portion of a lowered resistance value.

9. The method for manufacturing a semiconductor device as set forth in claim 8, wherein said ions irradiated onto said semiconductor are non-impurity ions.

10. The method for manufacturing a semiconductor device as set forth in claim 9, wherein said ions irradiated onto said semiconductor are any one of proton, deuteron, helium, and alpha particle.

11. The method for manufacturing a semiconductor device as set forth in claim 8, wherein temperature of heat treatment in said heat treatment process is not lower than 500 °C and not higher than 1400°C.

Fig.1

Fig.2

Fig.3

Fig.4

Fig.5

| | |
|---|---|
| P | ~2 |
| N⁻⁻ | ~1 |
| N⁺ | ~3 |

Fig.6

| | |
|---|---|
| P | ~2 |
| N⁻⁻ | ~1 |
| | ~4a |
| N⁺ | ~3 |

↑ ↑ ↑ ↑

Fig.7

Fig.8

Fig.9

Depth from the Proton
irradiation face(μm)

Fig·10

Fig·11

$$Q = \frac{1}{R}\sqrt{\frac{L}{C}}$$

Fig·12

Fig. 13

Fig : 14

Fig.15

Fig.16

Fig.17

Fig.18

Fig.19

Fig.20

| | |
|---|---|
| P | ~102 |
| N⁻⁻ | ~101 |
| N⁻ | ~103 |
| N⁺ | ~104 |

Fig.21

| | |
|---|---|
| ///////// | ~105 |
| P | ~102 |
| N⁻⁻ | ~101 |
| N⁻ | ~103 |
| N⁺ | ~104 |
| ///////// | ~106 |

# INTERNATIONAL SEARCH REPORT

| International application No. |
| --- |
| PCT/JP98/04055 |

| A. CLASSIFICATION OF SUBJECT MATTER |
| --- |
| Int.Cl⁶ H01L29/868 |

According to International Patent Classification (IPC) or to both national classification and IPC

| B. FIELDS SEARCHED |
| --- |

Minimum documentation searched (classification system followed by classification symbols)
Int.Cl⁶ H01L29/861, H01L29/868

Documentation searched other than minimum documentation to the extent that such documents are included in the fields searched

| | | | |
| --- | --- | --- | --- |
| Jitsuyo Shinan Koho | 1926-1996 | Toroku Jitsuyo Shinan Koho | 1994-1998 |
| Kokai Jitsuyo Shinan Koho | 1971-1998 | Jitsuyo Shinan Toroku Koho | 1996-1998 |

Electronic data base consulted during the international search (name of data base and, where practicable, search terms used)

| C. DOCUMENTS CONSIDERED TO BE RELEVANT | | |
| --- | --- | --- |
| Category* | Citation of document, with indication, where appropriate, of the relevant passages | Relevant to claim No. |
| X<br>Y<br>A | JP, 4-252078, A (Toshiba Corp.),<br>8 September, 1992 (08. 09. 92),<br>Examples ; Figs. 1 to 4<br>Examples ; Figs. 1 to 4<br>Examples ; Figs. 1 to 4<br>& EP, 497290, A2 & EP, 497290, A3<br>& KR, 9501170, B1 | 8-10<br>1, 2, 5<br>3, 4, 6, 7, 11 |
| Y | JP, 62-115880, A (Shindengen Electric Mfg.<br>Co., Ltd.),<br>27 May, 1987 (27. 05. 87),<br>Full text ; Figs. 3 to 5 (Family: none) | 1, 2, 5 |
| Y | JP, 8-316500, A (Mitsubishi Electric Corp.),<br>29 November, 1996 (29. 11. 96),<br>Full text ; Figs. 1 to 17<br>& EP, 749166, A1 & US, 5811873, A | 1, 2, 5 |

| ☒ Further documents are listed in the continuation of Box C. | ☐ See patent family annex. |
| --- | --- |

| * Special categories of cited documents: | "T" later document published after the international filing date or priority<br>date and not in conflict with the application but cited to understand<br>the principle or theory underlying the invention |
| --- | --- |
| "A" document defining the general state of the art which is not<br>considered to be of particular relevance | |
| "E" earlier document but published on or after the international filing date | "X" document of particular relevance; the claimed invention cannot be<br>considered novel or cannot be considered to involve an inventive step<br>when the document is taken alone |
| "L" document which may throw doubts on priority claim(s) or which is<br>cited to establish the publication date of another citation or other<br>special reason (as specified) | "Y" document of particular relevance; the claimed invention cannot be<br>considered to involve an inventive step when the document is |
| "O" document referring to an oral disclosure, use, exhibition or other<br>means | combined with one or more other such documents, such combination<br>being obvious to a person skilled in the art |
| "P" document published prior to the international filing date but later than<br>the priority date claimed | "&" document member of the same patent family |

| Date of the actual completion of the international search | Date of mailing of the international search report |
| --- | --- |
| 7 December, 1998 (07. 12. 98) | 15 December, 1998 (15. 12. 98) |

| Name and mailing address of the ISA/ | Authorized officer |
| --- | --- |
| Japanese Patent Office | |
| Facsimile No. | Telephone No. |

Form PCT/ISA/210 (second sheet) (July 1992)

**INTERNATIONAL SEARCH REPORT**

| International application No. |
| --- |
| PCT/JP98/04055 |

C (Continuation). DOCUMENTS CONSIDERED TO BE RELEVANT

| Category* | Citation of document, with indication, where appropriate, of the relevant passages | Relevant to claim No. |
| --- | --- | --- |
| A | JP, 57-103365, A (Nippon Telegraph & Telephone Public Corp.), 26 June, 1982 (26. 06. 82), Full text ; Figs. 3, 4 (Family: none) | 3, 4, 6, 7 |

Form PCT/ISA/210 (continuation of second sheet) (July 1992)